# EUROPÄISCHE PATENTSCHRIFT

(11) **EP 2 240 949 B1**
(45) Veröffentlichungstag und Bekanntmachung des Hinweises auf die Patenterteilung: **16.07.2014**
(21) Anmeldenummer: 09705113.0
(22) Anmeldetag: 30.01.2009
(51) Int. Cl.: H01H 13/02

(54) **NÄHERUNGSSCHALTER**
SENSOR
CAPTEUR

(30) Priorität: 30.01.2008 DE 102008006746; 13.02.2008 EP 08002680
(43) Veröffentlichungstag der Anmeldung: 20.10.2010
(73) Patentinhaber: Pepperl + Fuchs GmbH, 68307 Mannheim (DE)
(72) Erfinder: SCHOEN, Dierk, 63329 Egelsbach (DE)
(74) Vertreter: Schiffer, Axel Martin
(86) Internationale Anmeldenummer: PCT/EP2009/000614
(87) Internationale Veröffentlichungsnummer: WO 2009/095252

(56) Entgegenhaltungen:
- EP-A- 1 806 564
- WO-A-2005/022963
- US-A- 5 244 409

## Beschreibung

Die Erfindung betrifft einen Näherungsschalter zum Nachweis von Gegenständen nach dem Oberbegriff des Anspruchs 1.

Solche Näherungsschalter sind, beispielsweise aus DE 103 43 529 A1, in einer Vielzahl von Varianten bekannt. Insbesondere kann es sich um induktive, kapazitive oder Ultraschall-Näherungsschalter handeln.

Ein gattungsgemäßer Näherungsschalter weist folgende Komponenten auf: Eine Gehäusehülse, eine an einem Messende der Gehäusehülse angeordnete Wandlereinheit mit einer Wandleraufnahme und einem darin angeordneten Wand lerelement zum Nachweis einer physikalischen Messgröße und ein an einem Anschlussende des Gehäuses angeordnetes Anschlussstück. Weiterhin ist eine auf einer Leiterplatte angeordnete elektronische Baugruppe vorhanden, die in der Gehäusehülse aufgenommen ist und eine Steuer- und Auswerteeinheit aufweist, die zum Ansteuern des Wandlerelements, zum Auswerten von von dem Wandlerelement gemessenen Signalen und zum Abgeben von Schaltsignalen nach außen eingerichtet ist. Dabei sind schließlich auf der Leiterplatte am Messende und am Anschlussende verschiedenfarbige Leuchtdioden zum Signalisieren von Betriebs- und/oder Schaltzuständen angeordnet und die Wandleraufnahme weist einen um eine Gehäuseachse umlaufenden transparenten Bereich und/oder einen stirnseitigen transparenten Bereich auf.

Durch die optische Signalisierung können Schalt- und/oder Betriebszustände des Sensors, wie beispielsweise "Objekt erkannt", "kein Objekt erkannt" oder "Konfigurierung des Sensors", von einem Benutzer von außen erkannt werden.

Um auch eine größere Anzahl von unterschiedlichen Zuständen optisch zu signalisieren und gleichzeitig eine gute Rundumsichtbarkeit der optischen Signalisierung, also eine Sichtbarkeit aus möglichst jeder Raumrichtung zu erzielen, schlägt DE 103 43 529 A1 eine Vorrichtung vor, bei der ein transparentes Gehäuseteil durch geeignete Trennflächen in verschiedene Segmente unterteilt ist, in welchen entsprechende Leuchtmittel aufgenommen sind, Hierdurch kann insbesondere bei Sensoren mit einer Vielzahl von Schalt- und Betriebszuständen eine sehr gut sichtbare und deshalb ergonomische Signalisierung für einen Benutzer erzielt werden.

In der Praxis hat sich jedoch gezeigt, dass für viele Anwendungssituationen nur vergleichsweise wenige Schaltzustände nach außen signalisiert werden müssen und dass für solche Einsatzfälle die angesprochenen Trennflächen nicht notwendig und eher hinderlich sind.

In EP 1 806 564 A2 ist ein gattungsgemäßer Näherungsschalter beschrieben. Mit Hilfe eines transparenten Gehäuseabschlusses kann dort eine optische Signalisierung von Sensorzuständen an einer Anschlussseite des Sensorgehäuses erfolgen.

WO 2005/022963 A1 bezieht sich auf eine Beleuchtungsvorrichtung , bei der, abhängig von einer Annäherung einer Person, verschiedenfarbige Beleuchtungszustände verwirklicht werden.

Als eine **Aufgabe** der Erfindung kann angesehen werden, einen Näherungsschalter zum Nachweis von Gegenständen zu schaffen, der möglichst einfach aufgebaut ist und bei dem gleichwohl eine besonders gute Sichtbarkeit der Signalisierung in einem möglichst großen Raumbereich gegeben ist.

Diese Aufgabe wird durch den Näherungsschalter mit den Merkmalen des Anspruchs 1 gelöst.

Vorteilhafte Ausführungsbeispiele des erfindungsgemäßen Näherungsschalters werden nachstehend mit Bezug auf die abhängigen Ansprüche und insbesondere im Zusammenhang mit den beigefügten Figuren beschrieben.

Der Näherungsschalter der oben genannten Art ist erfindungsgemäß dadurch weitergebildet, dass das Anschlussstück einen transparenten umlaufenden Bereich aufweist, dass die transparenten Bereiche am Messende und am Anschlussende optisch homogen gebildet sind, dass die transparenten Bereiche mit den Leuchtdioden jeweils einfarbig ausleuchtbar sind und dass die Steuer- und Auswerteeinheit eingerichtet ist zum Ansteuern jeweils verschiedenfarbiger Leuchtdioden zum Signalisieren von verschiedenen Betriebs- und/oder Schaltzuständen.

Als ein Kerngedanke der Erfindung kann angesehen werden, sowohl am Messende als auch am Anschlussende der Gehäusehülse einen, insbesondere umlaufenden transparenten Bereich vorzusehen. Hierdurch wird zunächst eine gute Sichtbarkeit der Signalisierung in zwei Richtungen gewährleistet. Insbesondere ist deshalb der erfindungsgemäße Näherungsschalter besonders gut für Anwendungen geeignet, bei denen beidseitig einer Wand, beispielsweise einer Gehäusewand, eine Signalisierung erfolgen soll.

Sodann kann ein weiterer Kerngedanke der Erfindung darin gesehen werden, die transparenten Bereiche, also die Bereiche, über welche die optische Signalisierung nach außen erfolgt, jeweils umlaufend, also im Wesentlichen rotationssymmetrisch auszubilden. Hierdurch wird gewährleistet, dass die optische Signalisierung, beispielsweise auf einer Seite der Gehäusewand, umlaufend um den Sensor sichtbar ist.

Um die optische Signalisierung selbst effektiv zu bewerkstelligen, beinhaltet die vorliegende Erfindung als weiteren grundlegenden Gedanken schließlich, dass die transparenten Bereiche am Messende und am Anschlussende optisch homogen gebildet sind. Hierdurch soll insbesondere zum Ausdruck gebracht werden, dass im Unterschied zum Stand der Technik die jeweiligen transparenten Bereiche gerade keine Trennflächen aufweisen.

Die optische Signalisierung erfolgt deshalb bei dem erfindungsgemäßen Näherungsschalter so, dass ein bestimmter Schalt- oder Betriebszustand jeweils einer bestimmten Farbe zugeordnet ist und die Farben in diesem Sinn codiert sind. Wenn eine größere Zahl von Schalt- und/oder Betriebszuständen codiert werden soll, kann es zweckmäßig sein, dass die Steuer- und Auswerteeinheit darüber hinaus eingerichtet ist zum Ansteuern jeweils verschiedenfarbiger Leuchtdioden zum Signalisieren von verschiedenen Betriebs- und/oder Schaltzuständen in einer festgelegten zeitlichen Abfolge. Beispielsweise können die Leuchtdioden mit verschiedenen Frequenzen blinken.

Unter dem Begriff "optisch homogen" soll für die vorliegende Beschreibung im Wesentlichen eine solche optische Eigenschaft des entsprechenden Materials verstanden werden, die im Ergebnis dazu führt, dass der transparente Bereich für den Benutzer und den Betrachter einen homogenen Leuchteindruck vermittelt.

Unter dem Begriff "transparent" soll im Rahmen der vorliegenden Beschreibung im Wesentlichen verstanden werden, dass die so bezeichneten Bereiche für Licht, also elektromagnetische Strahlung des sichtbaren Bereichs, durchlässig sind. Es sollen hierunter aber auch solche Teile verstanden werden, bei denen das hindurchtretende Licht stark gestreut wird. Dies kann eine bevorzugte Variante sein, wenn der Aufwand an Leuchtmitteln reduziert werden soll, wenn also beispielsweise mit nur jeweils einer Leuchtdiode am Messende und am Anschlussende das Ausleuchten der transparenten Bereiche bewerkstelligt werden soll.

Um die gewünschten homogenen Eigenschaften der transparenten Bereiche zu erzielen, können die transparenten Bereiche bevorzugt einstückig aus einem optisch homogenen Material gebildet sein.

Bei einer besonders zweckmäßigen Variante sind die transparenten Bereiche aus einem transparenten Kunststoff spritzgegossen.

Ein besonderer Vorteil des erfindungsgemäßen Näherungsschalters ist außerdem darin zu sehen, dass durch die erfindungsgemäße Ausgestaltung der transparenten Bereiche der Aufwand an Leuchtmitteln insgesamt reduziert werden kann.

Um das Streuvermögen der transparenten Bereiche zu erhöhen, können in dem optisch homogenen Material, insbesondere mit im Wesentlichen konstanter Verteilungsdichte, entsprechende Streupartikel eingebracht sein.

Um eine möglichst gleichmäßige Ausleuchtung der transparenten Bereiche zu erzielen, sind die Leuchtdioden auf der Leiterplatte zweckmäßig beidseitig angeordnet.

Bei bevorzugten Ausführungsbeispielen des erfindungsgemäßen Näherungsschalters sind die Wandleraufnahme und/oder das Anschlussstück wenigstens teilweise aus einem transparenten Kunststoff gebildet. Das Licht der Leuchtmittel kann dann durch die Wandleraufnahme und/oder das Anschlussstück nach außen geleitet werden. Die Leuchtdioden werden bevorzugt im Bereich der Wandleraufnahme einerseits und im Bereich des Anschlussstücks andererseits angeordnet, so dass die Wandleraufnahme und das Anschlussstück die Funktion eines Lichtwellenleiters übernehmen. Die Wandleraufnahme kann bevorzugt durch Umspritzen eines Schirmbechers hergestellt werden. Hierdurch ergeben sich verbesserte Eigenschaften bei Hochspannungstests, Vereinfachungen beim Einspeisen eines Stroms sowie verbesserte EMV-Eigenschaften.

Die Ausleuchtung der transparenten Bereiche und deshalb die optische Signalisierung insgesamt kann verbessert werden, wenn an der Wandleraufnahme und/oder am Anschlussstück für jede Leuchtdiode jeweils mindestens ein Lichteinkoppelelement angeformt ist. Hierbei handelt es sich um entsprechende Formungen der Wandleraufnahme und des Anschlussstücks, welche das Eintreten des Lichts der Leuchtdioden in den transparenten Bereich begünstigen.

Bei einer weiteren bevorzugten Ausführungsvariante ist die Wandleraufnahme an dem Messende geschlossen. Dies kann dann von Vorteil sein, wenn der Näherungsschalter in einer Umgebung mit hohem Verschmutzungs- oder Feuchtigkeitseintrag verwendet werden soll.

Für solche Einsatzzwecke kann außerdem bevorzugt sein, wenn die Wandleraufnahme vom Messende bis zum Anschlussende durch die Gehäusehülse durchreicht und sich am Anschlussende mit dem Anschlussstück in einem dichtungsmäßigen Eingriff befindet. Es ist dann nur ein einziger dichtender Übergang vorhanden.

Das Anschlussstück kann als Kabelabgang oder als Steckerabgang ausgebildet sein.

Prinzipiell kann die elektronische Baugruppe auf mehrere Leiterplatten aufgeteilt sein. Besonders bevorzugt ist aber genau eine Leiterplatte vorhanden, die sich entlang der Achse der Gehäusehülse erstreckt.

Die Gehäusehülse kann grundsätzlich aus Kunststoff gefertigt sein. Besonders bevorzugt werden aber Metallhülsen eingesetzt, wobei zweckmäßig an einer Außenseite der Gehäusehülse geeignete Montagemittel vorhanden sind, um den Näherungsschalter an einer Wand zu montieren. Insbesondere handelt es sich dabei um eine durchgreifende Montage in dem Sinn, dass sich das Messende des Näherungsschalters auf einer Seite der Wand und das Anschlussende auf der anderen Seite der Wand befindet. Als Montagemittel kommt insbesondere ein auf der Außenseite der Gehäusehülse gebildetes Gewinde in Betracht, so dass der Näherungsschalter in die Wand eingeschraubt oder zunächst durchgesteckt und mit Muttern beidseitig festgehalten wird. Grundsätzlich kann die Außenseite des Gehäuses, beispielsweise für Anwendungen im Hygienebereich, auch glatt gebildet sein und als Montagemittel kann eine Klemmeinrichtung vorhanden sein.

Im Hinblick auf die Signalisierung der Schalt- und/oder Betriebszustände ist weiterhin bevorzugt, wenn die Leuchtdioden am Messende und die Leuchtdioden am Anschlussende, welche dieselbe Farbe aufweisen, jeweils parallel geschaltet sind.

Zur Verbesserung der Ausleuchtung der transparenten Bereiche können zweckmäßig für jede Farbe, beispielsweise für rot, grün und gelb, sowohl am Messende als auch am Anschlussende jeweils mehrere Leuchtdioden vorhanden sein.

Bei dem Wandlerelement kann es sich grundsätzlich um jedes physikalische Sensorelement handeln, welches zum Aufbau eines Näherungsschalters geeignet ist. Insbesondere kommen hier Wandlerelemente für induktive, kapazitive und/oder Ultraschall-Näherungsschalter in Betracht.

Bei einer besonders bevorzugten Ausgestaltung ist das Wandlerelement eine auf einen Spulenkörper gewickelte Induktionsspule eines induktiven Näherungsschalters. An der Leiterplatte kann dabei, insbesondere symmetrisch, eine Zunge gebildet sein, auf der Leuchtdioden angeordnet sind und welche in den Spulenkörper hineinragt oder durch den Spulenkörper hindurchragt. Mit diesen Leuchtdioden kann der stirnseitige transparente Bereich der Wandleraufnahme ausgeleuchtet werden.

Die Wandleraufnahme selbst kann grundsätzlich eine beliebige und an den jeweiligen Einsatzzweck angepasste Form aufweisen. Bei bevorzugten Varianten ist die Wandleraufnahme im Wesentlichen zylindrisch und ein Nachweisbereich des Wandlerelements erstreckt sich in Axialrichtung. Dies bedeutet, dass der Näherungsschalter bei axialer Annäherung eines nachzuweisenden Objekts schaltet. Bei beengten Platzverhältnissen können auch Ausführungsvarianten bevorzugt sein, bei denen sich ein Nachweisbereich des Wandlerelements quer, insbesondere senkrecht, der Gehäuseachse erstreckt.

In diesen Fällen kann eine dem Nachweisbereich des Wandlerelements abgewandte Seite der Wandleraufnahme, die dann auch als gewinkelte oder winklige Wandleraufnahmen bezeichnet wird, zur Signalisierung von Schalt- und/oder Betriebszuständen nutzbar gemacht werden. Bei einer bevorzugten Ausführungsvariante ist demgemäß an der Wandleraufnahme an einer dem Nachweisbereich des Wandlerelements abgewandten Seite mindestens ein weiterer transparenter Bereich zum Signalisieren von Schalt- und/oder Betriebszuständen des Näherungsschalters gebildet.

Die Steuer- und Auswerteeinheit kann bevorzugt in einem Mikrocontroller oder in einem programmierbaren Logikbaustein verwirklicht sein.

Weitere Vorteile und Merkmale der vorliegenden Erfindung werden nachstehend mit Bezug auf die schematischen Figuren im Einzelnen beschrieben.

Hierin zeigen:
- Fig. 1: in einer Explosionsdarstellung ein erstes Ausführungsbeispiel eines erfindungsgemäßen Näherungsschalters;
- Fig. 2: in einer Explosionsdarstellung ein zweites Ausführungsbeispiel eines erfindungsgemäßen Näherungsschalters;
- Fig. 3: eine Detailansicht des in Fig. 1 gezeigten Ausführungsbeispiels;
- Fig. 4: ein drittes Ausführungsbeispiel eines erfindungsgemäßen Näherungsschalters;
- Fig. 5: ein viertes Ausführungsbeispiel eines erfindungsgemäßen Näherungsschalters und
- Fig. 6: eine Teilansicht eines fünften Ausführungsbeispiels eines erfindungsgemäßen Näherungsschalters.

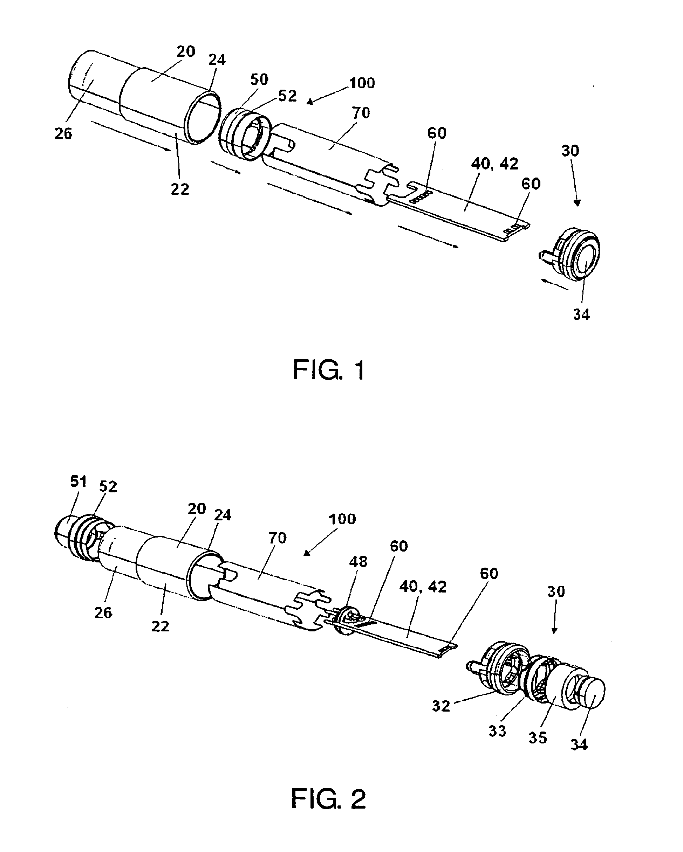

Zwei Ausführungsbeispiele eines erfindungsgemäßen Näherungsschalters 100 sind in den Figuren 1 und 2 dargestellt. Es handelt sich in beiden Fällen um zylindrische Ultraschallsensoren, die sich in ihrem Aufbau im Bereich eines Anschlussendes 26 unterscheiden. Bei dem in Fig. 1 gezeigten Beispiel ist ein dort nicht im Detail gezeigter Kabelabgang vorgesehen. Das in Fig. 2 dargestellte Beispiel weist einen Steckerabgang mit einem Steckermodul 48 auf.

In allen Figuren sind äquivalente Komponenten mit denselben Bezugszeichen versehen.

Als wesentliche Bestandteile beinhalten die in Figuren 1 und 2 gezeigten Näherungsschalter 100 jeweils eine Gehäusehülse 20, eine Wandlereinheit 30 und eine Leiterplatte 40 mit einer darauf angeordneten, jedoch nicht im Detail gezeigten elektronischen Baugruppe 42.

Zum Abschirmen der elektronischen Baugruppe 42 ist außerdem eine metallische Schirmhülse 70 vorhanden, in welche die Leiterplatte 40 im eingebauten Zustand eingeschoben ist. Die Leiterplatte 40 weist im Wesentlichen die Form eines länglichen Rechtecks auf und erstreckt sich im eingebauten Zustand entlang einer Gehäuseachse des Näherungsschalters 100. Die Wandlereinheit 30 ist im zusammengebauten Zustand in der Gehäusehülse 20 im Bereich eines Messendes 24 aufgenommen. An einem dem Messende 24 gegenüberliegenden Anschlussende 26 der Gehäusehülse 20 befindet sich, wie aus den Explosionsdarstellungen in Figuren 1 und 2 ebenfalls ersichtlich, ein Anschlussstück 50 für die Variante mit Kabelabgang in Fig. 1 sowie ein Anschlussstück 51 für die Variante mit Steckerabgang in Fig. 2. Das Anschlussstück 50 und das Anschlussstück 51 dienen dabei jeweils auch zum stabilen Positionieren der Leiterplatte 40 im Bereich des Anschlussendes 26 der Gehäusehülse 20.

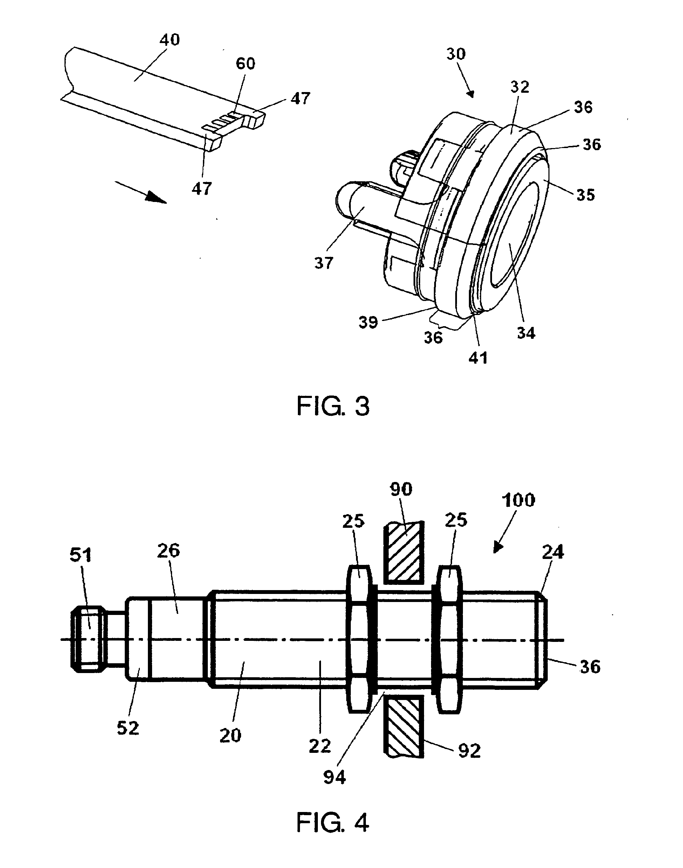

Der Steckerabgang bei der in Fig. 3 gezeigten Ausführungsvariante wird durch das Steckermodul 48, welches in dem Anschlussstück 21 aufgenommen und gehalten wird, bereitgestellt.

Zum Montieren des Näherungsschalters 100 ist an der Außenseite der Gehäusehülse 20 ein Gewinde 22 angeformt.

Die Wandlereinheit 30 beinhaltet, wie beispielsweise aus der Explosionsdarstellung in Fig. 2 ersichtlich, eine Wandleraufnahme 32, ein Wandlerelement 34, einen Schirmbecher 33 und eine Ausschäumung 35. Bei dem Wandlerelement 34 handelt es sich im gezeigten Beispiel um ein Ultraschall-Wandlerelement, welches zur akustischen Entkopplung zur Umgebung in die Ausschäumung 35 eingebettet ist. Prinzipiell kann es sich bei dem Wandlerelement aber um jedes Sensorelement handeln, welches zum Nachweis einer Annäherung eines Objekts geeignet ist. Insbesondere kann es sich bei einem induktiven Näherungsschalter um eine Messspule und bei einem kapazitiven Näherungsschalter um ein geeignetes kapazitives Sensorelement handeln.

Der Schirmbecher 33 dient zum Abschirmen von elektromagnetischen Störungen von außen und somit zum möglichst fehlerfreien Übertragen von Messsignalen des Wandlerelements 34 an die elektronische Baugruppe 42 und damit an die in den Figuren nicht im Detail gezeigte Steuer- und Auswerteeinheit.

Bei der Wandleraufnahme 32 kann es sich insbesondere um ein Kunststoff-Spritzteil handeln, welches um den Schirmbecher 33 herumgespritzt ist. Die Wandleraufnahme 32 erfüllt mechanische und optische Funktionen. Dies wird im Einzelnen im Zusammenhang mit Fig. 3 erläutert. Zunächst ist dort ersichtlich, dass die Leiterplatte 40 mit Hilfe von Zungen 47 in Führungsansätzen 37, die an der Wandleraufnahme 32 angeformt sind, aufgenommen und gehalten wird. Sodann ist gemäß einem wesentlichen Gedanken der vorliegenden Erfindung an der Wandleraufnahme 32 ein umlaufender transparenter Bereich 36 gebildet, der sich von einer Kante 39 bis zu einem Rand 41 der Ausschäumung 35 erstreckt. Dieser transparente Bereich 36, der auch als Leuchtfläche oder Leuchtbereich bezeichnet werden kann, ist erfindungsgemäß optisch homogen gebildet. Das bedeutet, dass dieser Bereich 36, wenn er von innen durch Leuchtdioden 60, welche auf der Leiterplatte 40 angeordnet und in Fig. 3 schematisch dargestellt sind, beleuchtet wird, für einen Betrachter von außen weitgehend homogen leuchtet. Insbesondere leuchtet der Bereich 36 einfarbig, wenn er von innen mit einer Leuchtdiode oder einer Mehrzahl von gleichfarbigen Leuchtdioden 60 beleuchtet wird.

In entsprechender Weise sind an dem Anschlussstück 50 in Fig. 1 und dem Anschlussstück 51 in Fig. 2 ein umlaufender transparenter Bereich 52 vorhanden und gebildet, die in demselben Sinn optisch homogen gebildet sind. Auch am Anschlussende 26 des erfindungsgemäßen Näherungsschalters 100 wird dadurch eine für einen Benutzer weitestgehend gleichmäßig und homogen strahlende Leuchtfläche bereitgestellt. Die erfindungsgemäß vorgesehenen transparenten Bereiche können auch als Leuchtbereiche oder Leuchtflächen bezeichnet und angesehen werden.

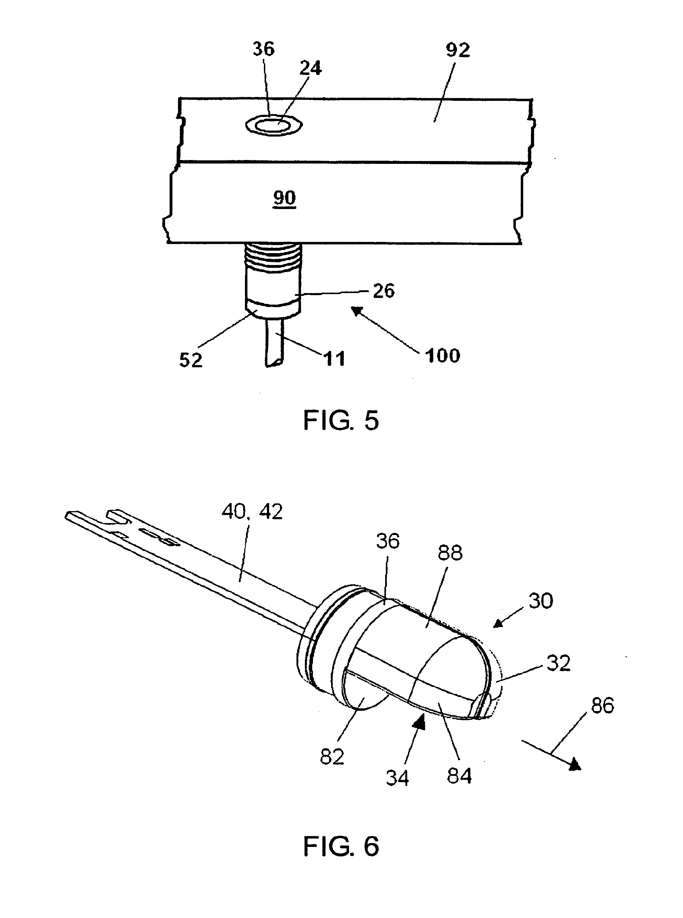

Der erfindungsgemäße Näherungsschalter eignet sich besonders gut für Einsatzzwecke, bei denen eine optische Signalisierung der Schalt- und/oder Betriebszustände auf beiden Seiten einer Wand erforderlich ist. Dies wird mit Bezug auf die Figuren 4 und 5 näher erläutert.

Fig. 4 zeigt ein Ausführungsbeispiel eines erfindungsgemäßen Näherungsschalters 100, der durchgreifend in einer Öffnung 94 einer Wand 90 montiert ist. Die Gehäusehülse 20 ist dabei durch die Öffnung 94 durchgesteckt und auf beiden Seiten der Wand 90 sind Muttern 25 auf das Gewinde 22 der Gehäusehülse 20 aufgeschraubt und halten diese in der Öffnung 94 fest. Das Messende 24 mit dem erfindungsgemäß vorhandenen umlaufenden transparenten Bereich 36 befindet sich dabei auf einer Sichtseite 92 der Wand 90. Dementsprechend liegt das Anschlussende 26 der Gehäusehülse 20 und das dort vorhandene Anschlussstück 51 mit dem daran erfindungsgemäß vorgesehen umlaufenden transparenten Bereich 52 auf der der Sichtseite 92 gegenüberliegenden Seite der Wand 90. Fig. 4 zeigt, dass mit dem erfindungsgemäßen Näherungsschalter 100 eine besonders gute optische Signalisierung der Schalt- und/oder Betriebszustände auf beiden Seiten einer Wand 90 erzielt werden kann.

Fig. 5 zeigt eine weitere Variante eines erfindungsgemäßen Näherungsschalters, der im Unterschied zu dem in Fig. 4 dargestellten Beispiel so in einer Wand 90 montiert ist, dass das Messende 24 bündig mit der Sichtseite 92 abschließt. Auch der erfindungsgemäß vorhandene umlaufende transparente Bereich 36 schließt dabei im Wesentlichen mit der Sichtseite 92 bündig ab. Ebenso ist im Bereich des Anschlussendes und eines Anschlusskabels 11 erfindungsgemäß ein umlaufender transparenter Bereich 52 vorgesehen.

Der erfindungsgemäße Näherungsschalter 100 kann auch direkt mit Hilfe des Gewindes 22, welches auf der Außenseite der Gehäusehülse 20 gebildet ist, in eine Öffnung einer Wand eingeschraubt werden. Außerdem kann, beispielsweise für Anwendungen im Hygienebereich, die Außenseite der Gehäusehülse 20 im Wesentlichen glatt gebildet und entsprechende Klemmmechanismen können vorhanden sein zum Befestigen der Gehäusehülse 20 in einer Öffnung einer Wand.

Ein fünftes Ausführungsbeispiel eines erfindungsgemäßen Näherungsschalters ist in einer Teilansicht in Fig. 6 dargestellt. Gezeigt ist in Fig. 6 eine Leiterplatte 40 mit einer daran angeordneten Wandlereinheit 30. Der wesentliche Unterschied dieses Ausführungsbeispiels zu den bisher beschriebenen Varianten besteht darin, dass ein Wandlerelement 34 so in eine Wandleraufnahme 32 eingesetzt ist, dass sich der Nachweisbereich dieses Wandlerelements 34 quer, insbesondere senkrecht, zu einer Achse 86 der Wandleraufnahme 32 erstreckt. Bei dem Wandlerelement 34 kann es sich insbesondere um ein Ultraschallwandlerelement handeln.

Wie bei den oben erläuterten Varianten ist bei dem in Fig. 6 gezeigten Beispiel ein umlaufender transparenter Bereich 36 vorgesehen, der auch als umlaufende Leuchtkante oder umlaufender Leuchtring bezeichnet werden kann.

Durch die im Vergleich zu den bisher beschriebenen Ausführungsbeispielen unterschiedliche Ausrichtung des Wandlerelements 34 ergeben sich für die Signalisierung von Schalt- und/oder Betriebszuständen des Näherungsschalters weitere Möglichkeiten. Beispielsweise können an der Wandleraufnahme 32 in den Bereichen 82, 84, 88 weitere transparente Bereiche gebildet sein, die zur Darstellung und Signalisierung von Schalt- und/oder Betriebszuständen nach außen durch innen liegende Leuchtdioden ausgeleuchtet werden können. Diese transparenten Bereiche weisen bevorzugt dieselben Eigenschaften wie die zuvor beschriebenen erfindungsgemäßen transparenten Bereiche auf, das heißt sie sind aus einem optisch homogenen Material gebildet und generieren deshalb für den Betrachter einen weitgehend gleichmäßigen Leucht- oder Helligkeitseindruck.

Prinzipiell ist auch möglich, die gesamte Wandleraufnahme 32 oder den gesamten vorne liegenden Teil, also den Teil der Wandleraufnahme 32, der in Fig. 6 rechts von dem umlaufenden transparenten Bereich 36 liegt, als transparenten Leuchtbereich zu bilden.

Je nachdem, wo im Einzelnen die transparenten Bereiche an oder in der Wandleraufnahme 32 gebildet sind, können im Innenbereich der Wandleraufnahme 32 lichtleitende Bereiche und Elemente gebildet sein.

Mit der vorliegenden Erfindung wird ein neuartiger Näherungsschalter bereitgestellt, der einerseits sehr einfach aufgebaut ist und mit dem andererseits eine besonders gute sichtbare Signalisierung von Betriebs- und/oder Schaltzuständen möglich ist.

## Patentansprüche

1. Näherungsschalter zum Nachweis von Gegenständen,
mit einer Gehäusehülse (20),
mit einer an einem Messende (24) der Gehäusehülse (20) angeordneten Wandlereinheit (30) mit einer Wandleraufnahme (32) und einem darin angeordneten Wandlerelement (34) zum Nachweis einer physikalischen Messgröße,
mit einem an einem Anschlussende (26) der Gehäusehülse (20) angeordneten Anschlussstück (50; 51),
mit einer auf einer Leiterplatte (40) angeordneten elektronischen Baugruppe (42), die in der Gehäusehülse (20) aufgenommen ist und eine Steuer- und Auswerteeinheit aufweist, die zum Ansteuern des Wandlerelements (34), zum Auswerten von von dem Wandlerelement (34) gemessenen Signalen und zum Abgeben von Schaltsignalen nach außen eingerichtet ist,
wobei das Anschlußstück (50; 51) einen transparenten umlaufenden Bereich (52) aufweist, der optisch homogen gebildet und mit Leuchtdioden einfarbig ausleuchtbar ist,
**dadurch gekennzeichnet,**
**dass** auf der Leiterplatte (40) am Messende (24) und am Anschlussende (26) verschiedenfarbige Leuchtdioden (60) zum Signalisieren von Betriebs- und/oder Schaltzuständen angeordnet sind,
**dass** die Wandleraufnahme (32) einen um eine Gehäuseachse umlaufenden transparenten Bereich (36) und/oder einen stimseitigen transparenten Bereich (52) aufweist, der optisch homogen gebildet und mit den Leuchtdioden (60) einfarbig ausleuchtbar ist und
**dass** die Steuer- und Auswerteeinheit eingerichtet ist zum Ansteuern jeweils verschiedenfarbiger Leuchtdioden (60) zum Signalisieren von verschiedenen Betriebs- und/oder Schaltzuständen.

2. Näherungsschalter nach Anspruch 1,
**dadurch gekennzeichnet,**
**dass** die transparenten Bereiche (36, 52) einstückig aus einem optisch homogenen Material gebildet sind.

3. Näherungsschalter nach Anspruch 1 oder 2,
**dadurch gekennzeichnet,**
**dass** die transparenten Bereiche (36, 52) aus einem transparenten Kunststoff spritzgegossen sind.

4. Näherungsschalter nach einem der Ansprüche 1 bis 3,
**dadurch gekennzeichnet,**
**dass** die Leuchtdioden (60) auf der Leiterplatte (40) beidseitig angeordnet sind.

5. Näherungsschalter nach einem der Ansprüche 1 bis 4,
**dadurch gekennzeichnet,**
**dass** die Wandleraufnahme (32) und/oder das Anschlussstück (50; 51) wenigstens teilweise aus einem transparenten Kunststoff gebildet sind.

6. Näherungsschalter nach einem der Ansprüche 1 bis 5,
**dadurch gekennzeichnet,**
**dass** an der Wandleraufnahme (32) und/oder am Anschlussstück (50; 51) für jede Leuchtdiode Lichteinkoppelelemente angeformt sind.

7. Näherungsschalter nach einem der Ansprüche 1 bis 6,
**dadurch gekennzeichnet,**
**dass** die Wandleraufnahme (32) am Messende (24) geschlossen ist.

8. Näherungsschalter nach einem der Ansprüche 1 bis 7,
**dadurch gekennzeichnet,**
**dass** die Wandleraufnahme (32) vom Messende (24) bis zum Anschlussende (26) durch die Gehäusehülse (20) durchreicht und sich am Anschlussende (26) mit dem Anschlussstück (50; 51) in einem dichtungsmäßigen Eingriff befindet.

9. Näherungsschalter nach einem der Ansprüche 1 bis 8,
**dadurch gekennzeichnet,**
**dass** die Leuchtdioden (60) am Messende (24) und die Leuchtdioden (60) am Anschlussende (26), welche dieselbe Farbe aufweisen, jeweils parallel geschaltet sind.

10. Näherungsschalter nach einem der Ansprüche 1 bis 9,
**dadurch gekennzeichnet,**
**dass** für jede Farbe sowohl am Messende (24) als auch am Anschlussende (26) jeweils mehrere Leuchtdioden (60) vorhanden sind.

11. Näherungsschalter nach einem der Ansprüche 1 bis 10,
**dadurch gekennzeichnet,**
**dass** das Wandlerelement (34) eine auf einen Spulenkörper gewickelte Induktionsspule eines induktiven Näherungsschalters beinhaltet und
**dass** an der Leiterplatte (40) eine Zunge gebildet ist, auf der Leuchtdioden angeordnet sind und welche in den Spulenkörper hineinragt, und
**dass** mit den auf der Zunge der Leiterplatte (40) angeordneten Leuchtdioden der stimseitige transparente Bereich der Wandleraufnahme (32) ausleuchtbar ist.

12. Näherungsschalter nach einem der Ansprüche 1 bis 11,
**dadurch gekennzeichnet,**
**dass** sich ein Nachweisbereich des Wandlerelements (34) quer, insbesondere senkrecht, zu einer Gehäuseachse (86) erstreckt.

13. Näherungsschalter nach Anspruch 12,
**dadurch gekennzeichnet,**
**dass** an der Wandleraufnahme (32) an einer dem Nachweisbereich des Wandlerelements (34) abgewandten Seite mindestens ein transparenter Bereich zum Signalisieren von Schalt- und/oder Betriebszuständen gebildet ist.

## Claims

1. Proximity sensor to detect objects, having
a housing sleeve (20),
a converter unit (30), arranged at a measuring end (24) of the housing sleeve (20), with a converter receiving element (32) and a converter element (34) arranged therein to detect a physical measurement value,
a connecting element (50; 51) arranged at a connecting end (26) of the housing sleeve (20),
an electronic assembly (42) arranged on a circuit board (40), said electronic assembly (42) being received in the housing sleeve (20) and comprising a control and evaluating unit which is adapted to control the converter element (34), to evaluate signals measured by the converter element (34) and to output switching signals outwards,
wherein the connecting element (50; 51) has a transparent surrounding region (52) which is optically homogeneously formed and can be illuminated in one colour with light emitting diodes,
**characterised in that**
different coloured light emitting diodes (60) are arranged on the circuit board (40) at the measuring end (24) and at the connecting end (26) to indicate operating and / or switching states,
the converter receiving element (32) has a transparent region (36) surrounding a housing axis and / or an end-face transparent region (52) which is optically homogeneously formed and can be illuminated in one colour with the light emitting diodes (60), and
the control and evaluating unit is adapted to control different coloured light emitting diodes (60) to indicate different operating and / or switching states.

2. Proximity sensor according to claim 1,
**characterised in that**
the transparent regions (36, 52) are integrally formed from an optically homogeneous material.

3. Proximity sensor according to claim 1 or 2,
**characterised** inthat
the transparent regions (36, 52) are injection moulded from a transparent plastic.

4. Proximity sensor according to one of the claims 1 to 3,
**characterised in that**
the light emitting diodes (60) are arranged on both sides of the circuit board (40).

5. Proximity sensor according to one of the claims 1 to 4,
**characterised in that**
the converter receiving element (32) and / or the connecting element (50; 51) are formed at least partially from a transparent plastic.

6. Proximity sensor according to one of the claims 1 to 5,
**characterised** inthat
light in-coupling elements are formed for each light emitting diode on the converter receiving element (32) and/ or on the connecting element (50; 51).

7. Proximity sensor according to one of the claims 1 to 6,
**characterised in that**
the converter receiving element (32) is closed at the measuring end (24).

8. Proximity sensor according to one of the claims 1 to 7,
**characterised in that**
the converter receiving element (32) extends from the measuring end (24) to the connecting end (26) through the housing sleeve (20) and is located at the connecting end (26) in a sealing engagement with the connecting element (50; 51).

9. Proximity sensor according to one of the claims 1 to 8,
**characterised in that**
the light emitting diodes (60) at the measuring end (24) and the light emitting diodes (60) at the connecting end (26) which are the same colour are respectively connected in parallel.

10. Proximity sensor according to one of the claims 1 to 9,
**characterised in that**
for each colour a plurality of light emitting diodes (60) are present, in each case, both at the measuring end (24) and also at the connecting end (26).

11. Proximity sensor according to one of the claims 1 to 10,
**characterised in that**
the converter element (34) contains an induction coil of an inductive proximity sensor wound onto a coil body, and
a tongue is formed on the circuit board (40), on which tongue light emitting diodes are arranged and which projects into the coil body, and
the end-face transparent region of the converter receiving element (32) can be illuminated with the light emitting diodes arranged on the tongue of the circuit board (40).

12. Proximity sensor according to one of the claims 1 to 11,
**characterised in that**
a detection region of the converter element (34) extends transverse, in particular perpendicular, with respect to a housing axis (86).

13. Proximity sensor according to claim 12,
**characterised in that**
at least one transparent region is formed on the converter receiving element (32) on a side facing away from the detection region of the converter element (34) to indicate switching and / or operating states.

## Revendications

1. Capteur de proximité pour la détection d'objets,
avec un manchon de boîtier (20),
avec une unité de transduction (30) disposée à une extrémité de mesure (24) du manchon de boîtier (20) et pourvue d'un logement de transducteur (32) et d'un élément transducteur (34) disposé à l'intérieur de ce dernier pour la détection d'une grandeur de mesure physique,
avec un élément de raccordement (50 ; 51) disposé à une extrémité de raccordement (26) du manchon de boîtier (20),
avec un sous-ensemble électronique (42) disposé sur une carte de circuit imprimé (40) et qui est logé dans le manchon de boîtier (20) et comprend une unité de commande et de traitement, cette dernière étant agencée pour la commande de l'élément transducteur (34), pour le traitement de signaux mesurés par l'élément transducteur (34) et pour la transmission de signaux de connexion vers l'extérieur,
dans lequel l'élément de raccordement (50; 51) comprend une zone périphérique transparente (52), qui est optiquement formée de manière homogène et qui peut être éclairée en une couleur avec des diodes électroluminescentes, **caractérisé :**
**en ce que** des diodes électroluminescentes (60) de couleurs différentes sont disposées sur la carte de circuit imprimé (40), à l'extrémité de mesure (24) et à l'extrémité de raccordement (26), pour la signalisation d'états de fonctionnement et/ou d'états de connexion,
**en ce que** le logement de transducteur (32) comprend une zone transparente (36) entourant un axe de boîtier et/ou une zone transparente (52) frontale, qui est optiquement formée de manière homogène et qui peut être éclairée en une couleur avec les diodes électroluminescentes (60), et
**en ce que** l'unité de commande et de traitement est agencée pour la commande de chacune des diodes électroluminescentes (60) de couleurs différentes, pour la signalisation de différents états de fonctionnement et/ou états de connexion.

2. Capteur de proximité selon la revendication 1,
**caractérisé :**
**en ce que** les zones transparentes (36, 52) sont formées intégralement en un matériau optiquement homogène.

3. Capteur de proximité selon la revendication 1 ou 2,
**caractérisé :**
**en ce que** les zones transparentes (36, 52) sont moulées par injection à partir d'un matériau transparent.

4. Capteur de proximité selon une des revendications 1 à 3,
**caractérisé :**
**en ce que** les diodes électroluminescentes (60) sont disposées sur la carte de circuit imprimé (40), des deux côtés de celle-ci.

5. Capteur de proximité selon une des revendications 1 à 4,
**caractérisé :**
**en ce que** le logement de transducteur (32) et/ou l'élément de raccordement (50 ; 51) sont formés au moins en partie en un matériau transparent.

6. Capteur de proximité selon une des revendications 1 à 5,
**caractérisé :**
**en ce que**, pour chaque diode électroluminescente, des éléments de couplage lumineux sont formés sur le logement de transducteur (32) et/ou sur l'élément de raccordement (50 ; 51).

7. Capteur de proximité selon une des revendications 1 à 6,
**caractérisé :**
**en ce que** le logement de transducteur (32) est fermé à l'extrémité de mesure (24).

8. Capteur de proximité selon une des revendications 1 à 7,
**caractérisé :**
**en ce que** le logement de transducteur (32) passe à travers le manchon de boîtier (20), de l'extrémité de mesure (24) jusqu'à l'extrémité de raccordement (26), et se trouve en prise étanche avec l'élément de raccordement (50 ; 51) à l'extrémité de raccordement (26).

9. Capteur de proximité selon une des revendications 1 à 8,
**caractérisé :**
**en ce que** les diodes électroluminescentes (60) de l'extrémité de mesure (24) et les diodes électroluminescentes (60) de l'extrémité de raccordement (26) qui comprennent la même couleur sont connectées chacune respectivement en parallèle.

10. Capteur de proximité selon une des revendications 1 à 9,
**caractérisé :**
**en ce que**, pour chaque couleur, plusieurs diodes électroluminescentes (60) sont à chaque fois présentes, aussi bien à l'extrémité de mesure (24) qu'également à l'extrémité de raccordement (26).

11. Capteur de proximité selon une des revendications 1 à 10,
**caractérisé :**
**en ce que** l'élément transducteur (34) contient une bobine d'induction - enroulée sur un corps de bobine - d'un capteur de proximité inductif, et
**en ce que**, sur la carte de circuit imprimé (40), une languette est formée, sur laquelle des diodes électroluminescentes sont disposées, et qui pénètre dans le corps de bobine, et
**en ce que** la zone transparente frontale du logement de transducteur (32) peut être éclairée avec les diodes électroluminescentes disposées sur la languette de la carte de circuit imprimé (40).

12. Capteur de proximité selon une des revendications 1 à 11,
**caractérisé :**
**en ce qu'**une zone de détection de l'élément transducteur (34) s'étend transversalement, et plus particulièrement perpendiculairement, à un axe de boîtier (86).

13. Capteur de proximité selon la revendication 12,
**caractérisé :**
**en ce que**, sur le logement de transducteur (32), sur un côté situé à l'opposé de la zone de détection de l'élément transducteur (34), au moins une zone transparente est formée pour la signalisation d'états de connexion et/ou d'états de fonctionnement.
